# EUROPEAN PATENT APPLICATION

(11) **EP 1 217 733 A1**
(43) Date of publication of application: **26.06.2002**
(21) Application number: 00311418.8
(22) Date of filing: 20.12.2000
(51) Int. Cl.: H03H 7/46, H01P 1/213

(54) **Filtercombiner with broadband branch**

(71) Applicant: LUCENT TECHNOLOGIES INC., Murray Hill, New Jersey 07974-0636 (US)
(72) Inventor: Loeffler, Christoph, 90403 Nürnberg (DE)
(74) Representative: Buckley, Christopher Simon Thirsk

(57) **Abstract**

The invention relates to an improved and more effective way of using narrowband and broadband systems by decreasing the amount of individual antennas inclusive feeder cables.

According to the invention it is proposed and used a filtercombiner which incorporates at least one passband filter (F_{1N}, F_{2N}) and at least one stopband filter (F_{2B}, F_{3B}, F_{4B}) adapted to combine at least one narrowband carrier signal with a broadband carrier signal (Fig. 1).

## Description

The invention relates to a filtercombiner and to a transceiver unit including such a filtercombiner.

Filtercombiner are commonly used in narrowband systems such as mobile communication systems like GSM (Global System for Mobile communication) and TDMA (Time Division Multiple Access) for example.

In this systems the purpose of the filtercombiner is to combine several carriers with different frequencies to one antenna. The big advantage of a filtercombiner compared to other combining techniques is the low insertion loss or in other words the small attenuation applied on the combined carriers. With ideal components the insertion loss approaches to zero.

In practice, these combiners comprise tunable cavity filters. The tuning range of such tunable filter usually covers the whole range in which the system is working. For example, a cavity filter of a GSM900 combiner can be tuned within the range of 925MHz to 960MHz, which is the whole transmit band for GSM900 in downlink direction.

Since this type of combiner, however, is missing the possibility to combine a broadband or a multi-carrier signal, a separate antenna has to be provided for each broadband or multi-carrier signal. Thus, due to the steady increasing need for broadband communication systems, such as CDMA (Code Division Multiple Access)-systems, and/or UMTS (Universal Mobile Telecommunication System)-systems and/or the need for combining multi-carrier-signals, formed for example by a TDMA-system, with GSM narrowband signals, the amount of individual antennas as necessary for covering the blanket area is correspondingly increasing. Additionally, an increasing amount of antennas often spoil the general impression of building facades.

It has to be noted, that for the following description and the appended set of claims both a broadband signal and a multi-carrier-signal is in general called a broadband signal.

An object of the invention is to provide an improved and more effective way of using narrowband and broadband systems by decreasing the amount of individual antennas as well as their respective feeder cables.

The inventive solution of the object is achieved by a filtercombiner and a transceiver unit according to claim 1 and 10, respectively.

According to the invention a filtercombiner is proposed and used which incorporates at least one passband filter and at least one stopband filter adapted to combine at least one narrowband carrier signal with a broadband signal.

Consequently the inventive solution provides a very efficient and effective possibility to add narrowband carriers at frequencies unused by an broadband system to a broadband carrier before the combined frequencies are fed to an common antenna.

To provide a very simple and inexpensive filtercombiner it is proposed to realize a passband filter and a stopband filter (i.e. a notch filter) by use of cavity filters each of the filters resulting in an arrangement of single-circuit filters.

According to preferred embodiments of the invention, especially to de-couple the inputs of the filters as used, it is proposed to adapt the passband filter for a respective narrowband carrier signal such that the center frequency is tuned to said narrow carrier signal by reflecting and/or isolating the frequency bands of each other carrier signal to be combined and to provide for the broadband branch a respective stopband filter, the center frequency of which is adapted to said passband filter.

Preferably, all filters are tunable filters to be tuned within a definable transmit band.

According to preferred embodiments a transceiver unit including such a filtercombiner is adapted to be used to combine carriers of a GSM-system with carriers of a TDMA-system or carriers of a GSM-system with a carrier of a CDMA-system.

With the inventive approach it is possible even to use one frequency band for different network systems by merely using the existing antenna units, i.e. without an increasing of the amount of the antennas and their respective feeder-cables. For example, the 850 MHz frequency band of a TDMA-multi-carrier-system can be used for a GSM850-system and the 1900 MHz frequency band of the GSM1900 system may be additionally used by the UMTS-system. Furthermore, especially with respect to an UMTS-amplifier having a low degree of effectiveness the inventive tunable filtercombiner provides a very useful alternative in comparison with a hybridcombiner, since a hybridcombiner provides a flexibility similar to a filtercombiner in combining different carriers to one antenna but also causes a loss of at least about 3dB.

Further advantages are evident from the following description of the invention in detail, in particular on the basis of preferred exemplary embodiments, with reference to the attached drawings, in which:
- Fig. 1: schematically shows a first embodiment of a filtercombiner with a narrowband branch and a broadband branch according to the invention,
- Fig. 2: schematically shows a second embodiment of a filtercombiner with multiple narrowband branches and a broadband branch according to the invention,
- Fig. 3: shows a conventional filtercombiner,
- Fig. 4: schematically shows an equivalent circuit diagram of the filtercombiner according to fig. 1,
- Fig. 5: schematically shows an exemplary application of the invention concerning a co-siting of a GSM-system and a TDMA-multi-carrier-system, and
- Fig. 6: schematically shows a second exemplary application of the invention concerning a co-siting of a GSM-system and a CDMA/UMTS-system.

For the following description it has to be noted that equal or equally acting components are labeled with equal reference signs within the figures. Furthermore, it is assumed that each input port IN₁, IN₂, IN₃ and each output port OUT is related to a certain impedance, such as 50Ω for example as usually in practice, and each port is matched.

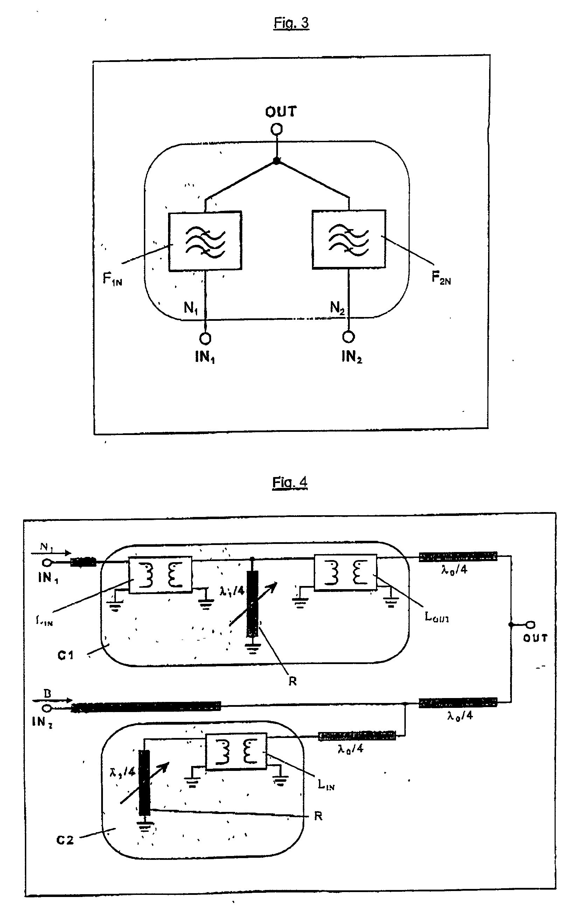

Prior to a detailed description of preferred exemplary embodiments of the invention, reference firstly being made to Fig. 3 showing a greatly simplified and schematic representation of a conventional filtercombiner.

The filtercombiner of Fig. 3 includes two narrowband-branches N₁ and N₂, each of which comprises a passband filter F_{1N} or F_{2N} that is connected to one common output OUT. Into each input IN₁ and IN₂ a narrowband carrier is fed to be combined to the common output OUT. The center frequency of the passband filter F_{1N} is adapted to the narrowband carrier that is fed into branch N₁ via input IN₁ and, accordingly, the center frequency of the passband filter F_{2N} is adapted to the narrowband carrier that is fed into branch N₂ via input IN₂.

As known for a person skilled in the art, for combining more than two narrowband carriers it is necessary to further add a respective branch having a passband filter for each additional carrier. The outputs of the additional passband filters are also connected to the common combiner output.

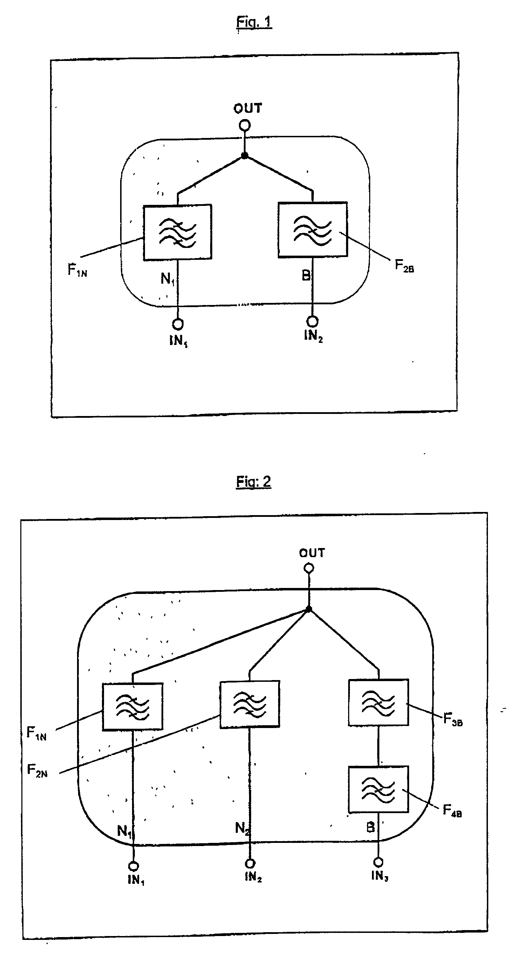

Regarding Fig. 1 and 2 exemplary representations of the inventive approach providing the combination of at least one narrowband signal with a broadband signal to a common output OUT.

The combiner of Fig. 1 includes a narrowband-branch N₁ with a passband filter F_{1N} having an input port IN₁ adapted to the feeding in of a first narrowband signal and a broadband-branch B with a filter F_{2B} having an input port IN₂ adapted to the feeding in of a broadband signal.

According to the above described conventional filtercombiner, the center frequency and bandwidth of filter F_{1N} is adapted to the narrowband signal that is fed into input IN₁.

To make the combiner work it is necessary that the inputs IN1 and IN2 are de-coupled or have at least a certain isolation between each other in the frequency band of the narrowband carrier and in the frequency band of the broadband carrier or the occupied frequencies of the multi-carrier signal.

At the interconnection between narrowband branch N1, broadband branch B and the line to an antenna via the output OUT, the broadband branch B has to be isolate for the narrowband signal and the narrowband branch has to be isolate for the broadband/multi-carrier signal.

If this condition would be not fulfilled the narrowband signal would meet a parallel circuit of the broadband branch with the antenna line and the broadband/multi-carrier signal would meet a parallel circuit of the narrowband branch with the antenna line. This parallel circuit would cause reflections resulting in approximately 3dB loss. Furthermore, a splitting of the signal to the antenna and to the broadband/narrowband branch would cause additional 3dB loss.

Thus, at the passband frequency of filter F_{1N} or at least at the frequency band at which the narrowband carrier fed into filter F_{1N} is operating filter F_{2B} should be in a stopband condition, i.e. filter F_{2B} should be reflective or isolate.

For the realization of the required de-coupling of the inputs IN₁ and IN₂ a stopband filter based on a cavity filter is preferably applied to filter F_{2B} for the broadband signal. By using a stopband filter as filter F_{2B}, its center frequency and bandwidth is adapted to the narrowband carrier that is fed into input IN₁ and/or to the center frequency of filter F_{1N}. As a consequence, filter F_{2B} provides a broadband RF-branch B to the common output OUT excluding the stopband of filter F_{2B}, i.e. the passband frequency of the narrowband filter F_{1N}

A preferred physical realization of the inventive filtercombiner according to Fig. 1 is schematically depicted in Fig. 4. Filter F_{1N} of the narrowband-branch N₁ with the input port IN₁ adapted to the narrowband signal includes a cavity C₁, made of aluminia for example, with a tunable cavity resonator R of high dielectric ceramic material and two coupling loops L_{IN} and L_{OUT} to couple an electromagnetic wave in and out, respectively.

As usually, the ceramic resonator R itself may consist of two cylindrical parts, with one part of which fixed and the other part movably arranged to manipulate the resonance frequency of the filter. For ensuring a remote tuning of the filter, a stepper motor commonly controls the moving part of the resonator.

Filter F_{2B} of the broadband-branch B with the input port IN₂ adapted to the broadband signal can be in substantial realized like a "normal" cavity filter, i.e. like filter F_{1N}, but without an output and hence operating as stopband filter F_{2B} with the stopband frequency adapted to the center frequency of filter F_{1N}. The high impedance at the resonant frequency of filter F_{2B} is transformed into a low impedance/short by a λ/4 line.

Thus, at the center frequency the length of the equivalent transmission lines inside the cavities C₁ and C₂ correspond to λ₁/4 with λ₁ being the wavelength related to the center frequency of the narrowband carrier and outside the cavities to λ₀/4, with λ₀ being the wavelength related to the center of the entire frequency-band the combiner is operating. Furthermore, according to the above assumption, each port is related to 50Ω.

Based on the combiner having two single-circuit filters F_{1N} and F_{2B} for combining a narrowband signal with a broadband signal to a common output OUT, as described above, it is further possible to enhance the quantity of the narrowband carriers. For each additional narrowband carrier merely an additional passband filter respectively stopband (notch) filter is required. The respective additional stopband filter is required to achieve the de-coupling of the input for the additional narrowband carrier with the broadband branch.

An example of a dual narrowband combiner with an additional broadband branch is shown in figure 2.

Regarding that inventive dual narrowband combiner with a broadband branch, filter F_{1N} with the input port IN₁ adapted to a first narrowband signal and filter F_{3B} of the broadband branch B as well as filter F_{2N} with the input port IN₂ adapted to a second narrowband signal and filter F_{4B} of the broadband branch B are corresponding with each other, i.e. filter F_{1N} and filter F_{3B} are tuned to the same center frequency as well as filter F_{2N} and filter F_{4B}.

Accordingly, for a further increasing of the quantity of narrowband carriers, every additional passband filter is connected with its output to the common combiner output. Its input is the input for the carrier that has to be added to the common output. The respective complementary filter for de-coupling reasons, i.e. the notch filter to be added to the broadband branch is connected in series to the broadband branch. The stopband of this notch is tuned to the passband of the respective filter or narrowband carrier. Hence, each additional notch filter causes an additional gap in the broadband branch.

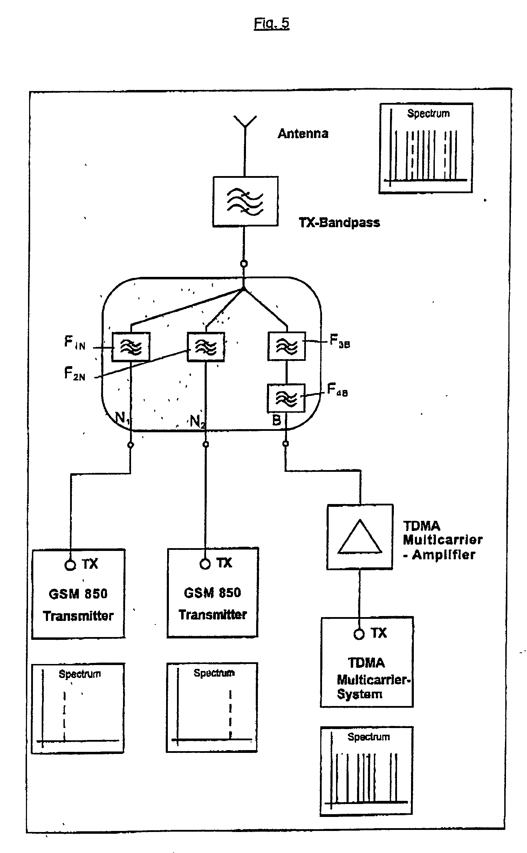

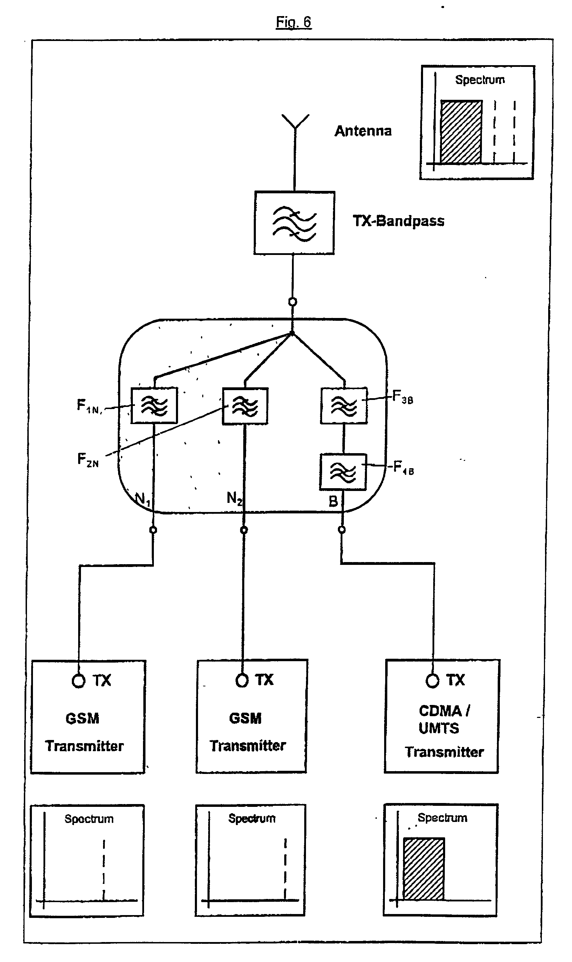

Fig. 5 and 6 schematically show exemplary applications of a combined transmitting of two GSM-signals and a TDMA-multi-carrier-signal and of two GSM-signals and a CDMA or UMTS-signal, respectively.

Regarding first the combination of the TDMA-multi-carrier system with a GSM850 system, the TDMA and the GSM system according to Fig. 5 both are operating in the same frequency band of about 869MHz to 894MHz. Just the respective carriers have different frequencies. At a transceiver unit incorporated within a base station for example, the received carriers of the TDMA-system are combined to a multi-carrier-system and amplified before entering the broadband branch B of the filtercombiner incorporated within that transceiver unit. Through the two narrowband branches N1 and N2 of the filtercombiner two received GSM carriers are added at frequencies unused by the TDMA-system. An optional transmit bandpass, having a passband of 869MHz...894MHz, for filtering noise in the receiving band is used before the combined frequencies are fed to an antenna of the transceiver unit for further radio transmitting. The different spectra of the GSM and TDMA signals before and of the combined signal after passing the filtercombiner are depicted in Fig. 5.

Fig. 6 is depicting the combination of a CDMA or UMTS System with a GSM System. The CDMA or UMTS System and the GSM system may operate in equal (with the respective carriers having different frequencies) or in different frequency bands. The received broadband carrier signal of the CDMA-System enters the broadband branch B of the filtercombiner incorporated within a transceiver unit. Correspondingly to Fig. 5, through the two narrowband branches N1 and N2 of the filtercombiner the two received GSM carriers are added at frequencies unused by the CDMA-system. Additionally, an optional transmit bandpass, having an appropriate passband for filtering noise in the receiving band is used before the combined frequencies are fed to the antenna of the transceiver unit for further radio transmitting. The different spectra of the GSM and CDMA signals before and of the combined signal after passing the filtercombiner also are depicted in Fig. 6.

It should be obvious for a person skilled in the art, that the exemplary embodiments of the invention as described with reference to the accompanied figures are varying with regard to and can be adapted to specific applications without departing the scope of the invention.

For example, the invention also is covering embodiments, wherein at least two inventive combiners are cascaded, so that the output of a first combiner is connected to the input port of the broadband branch of a second combiner.

## Claims

1. Filtercombiner, **characterized by** at least one passband filter (F_{1N}, F_{2N}) and at least one stopband filter (F_{2B}, F_{3B}, F_{4B}) adapted to combine at least one narrowband carrier signal with a broadband signal.

2. Filtercombiner of claim 1, comprising for the broadband signal a broadband-branch (B) having for each passband filter (F_{1N}, F_{2N}) a respective stopband filter (F_{2B}, F_{3B}, F_{4B}), the center frequency of which is adapted to said passband filter (F_{1N}, F_{2N}).

3. Filtercombiner of claim 1 or 2, comprising for each narrowband carrier signal a respective narrowband-branch (N₁, N₂) having a pasaband filter (F_{1N}, F_{2N}), the center frequency of which is adapted to the narrowband carrier fed into said narrowband-branch (N₁, N₂).

4. Filtercombiner of claim 1, 2 or 3, comprising for each narrowband carrier signal a respective passband filter (F_{1N}, F_{2N}) reflecting and/or isolating the frequency band of each of the other,carrier signals.

5. Filtercombiner of any of claims 1 to 4, wherein each stopband filter (F_{2B}, F_{3B}, F_{4B}) is connected in series to the broadband-branch (B).

6. Filtercombiner of any of claims 1 to 5, wherein each passband filter is a cavity filter (F_{1N}, F_{2N}) and each stopband filter is a cavity filter (F_{2B}, F_{3B}, F_{4B}).

7. Filtercombiner of any of claims 1 to 6, wherein each filter is a tunable filter (F_{1N}, F_{2N}, F_{2B}, F_{3B}, F_{4B}).

8. Filtercombiner of any of claims 1 to 7, wherein the output of each filter (F_{1N}, F_{2N}, F_{2B}, F_{3B}, F_{4B}) used to combine at least one narrowband carrier signal with a broadband carrier signal is connected to one common output (OUT).

9. Filtercombiner, wherein the output (OUT) of a first filtercombiner of any of claims 1 to 8 is connected to the input for the broadband signal of a second filtercombiner of any of claims 1 to 8.

10. Transceiver unit, **characterized by** a filtercombiner according to any of claims 1 to 9.

11. Transceiver unit of claim 10, adapted to be used in telecommunication systems.

12. Transceiver unit of claim 10 or 11, adapted to be used to combine carriers of a GSM-system with carriers of a TDMA-multi-carrier-system.

13. Transceiver unit of claim 10 or 11, adapted to be used to combine carriers of a GSM-system with a carrier of a CDMA-system.
